# EUROPEAN PATENT SPECIFICATION

(11) **EP 0 510 670 B1**
(45) Date of publication and mention of the grant of the patent: **25.09.1996**
(21) Application number: 92107033.0
(22) Date of filing: 24.04.1992
(51) Int. Cl.: G03F 7/004, G03F 7/022

(54) **Positive resist composition**
Positivarbeitende Resistzusammensetzung
Composition par photoréserve positive

(30) Priority: 26.04.1991 JP 97267/91; 29.11.1991 JP 316499/91
(43) Date of publication of application: 28.10.1992
(73) Proprietor: SUMITOMO CHEMICAL COMPANY, LIMITED, Chuo-ku Osaka 541 (JP)
(72) Inventor: Uetani, Yasunori, Toyonaka-shi, Osaka-fu (JP); Doi, Yasunori, Takatsuki-shi, Osaka-fu (JP); Hashimoto, Kazuhiko, Ibaraki-shi, Osaka-fu (JP); Osaki, Haruyoshi, Toyonaka-shi, Osaka-fu (JP); Hanawa, Ryotaro, Ibaraki-shi, Osaka-fu (JP)
(74) Representative: VOSSIUS & PARTNER

(56) References cited:
- EP-A- 0 273 026
- EP-A- 0 275 970
- EP-A- 0 346 808

## Description

The present invention relates to a positive resist composition which comprises a quinone diazide compound, an alkali-soluble resin and a specific solvent.

A composition containing a compound having a quinone diazide group (a quinone diazide compound) and an alkali-soluble resin finds use as a positive resist in the production of integrated circuits.

Recently, with integrated circuits, miniaturization has proceeded with a rise in the integration level, which results in demands for formation of patterns of sub-micron order. To form such minute patterns with good reproducibility, it is essential that a uniform resist coating is formed and that the resist composition has a larger depth of focus.

Hitherto, for the preparation of the resist composition, a cellosolve type solvent has been used as a solvent. In view of health problems of human beings, some solvents such as propylene glycol monomethyl ether acetate, cyclohexanone and ethyl lactate are proposed as substitutes for the cellosolve type solvent. However, the use of propylene glycol monomethyl ether acetate or cyclohexanone will decrease heat resistance of the resist. The use of ethyl lactate having a high viscosity will increase striations or cause some problem in coating such that an edge of a wafer is not coated.

EP-A-0 273 026 discloses photoresist processes and compositions having high resolution photoactive components with several diazoquinone groups per molecule.

An object of the present invention is to provide a positive resist composition comprising other than cellosolve type solvents which is excellent in coating properties and has a good profile and a large depth of focus while maintaining other properties required for a resist such as good heat resistance, high resolution and good sensitivity.

According to the present invention, there is provided a positive resist composition comprising, in admixture, an alkali-soluble resin, a quinone diazide compound and a mixed solvent of ethyl lactate and 2-heptanone in a weight ratio of 5:95 to 80:20.

In the positive resist composition of the present invention, a quinone diazide compound may be any one of conventionally used compounds. For example, a quinone diazide compound is an ester of a below described hydroxyl group-containing compound with a quinone diazide sulfonic acid such as 1,2-benzoquinone diazide-4-sulfonic acid, 1,2-naphthoquinone diazide-4-sulfonic acid or 1,2-naphthoquinone diazide-5-sulfonic acid. Preferably, a quinone diazide compound is an ester of a hydroxyl group-containing compound of the formula: 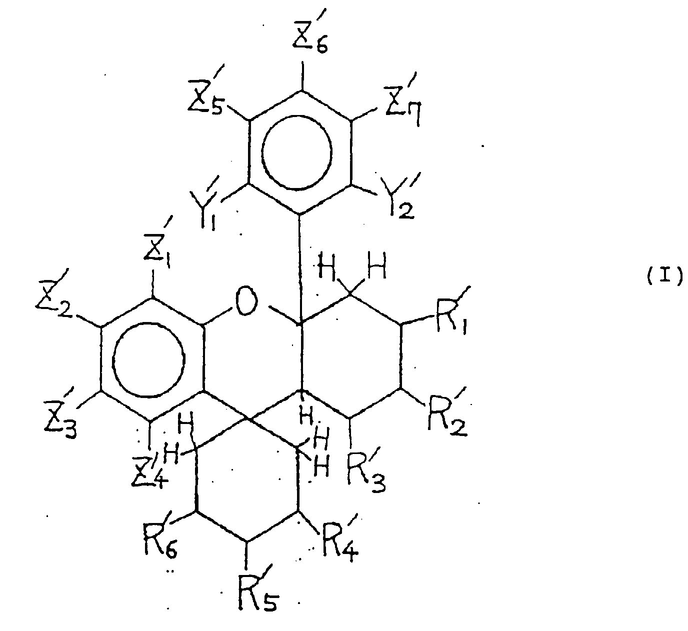 wherein Y₁', Y₂', Z₁', Z₂', Z₃', Z₄', Z₅', Z₆' and Z₇' are the same or different and each represents a hydrogen atom, a hydroxyl group or a C₁-C₄ alkyl group, provided that at least one of Y₁' and Y₂' is a hydroxyl group and at least two of Z₁', Z₂', Z₃', Z₄', Z₅', Z₆' and Z₇' are hydroxyl groups; and R₁', R₂', R₃', R₄', R₅' and R₆' are the same or different and each represents a hydrogen atom, a C₁-C₁₀ alkyl group, a C₂-C₄ alkenyl group, a C₅-C₈ cycloalkyl group or an aryl group, or an oxyflavan compound of the formula: 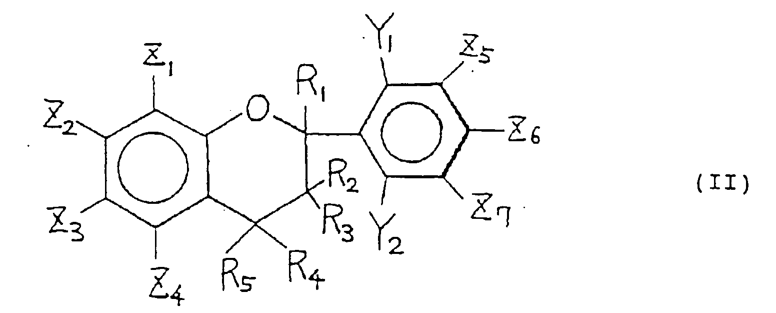 wherein Y₁ and Y₂ are the same or different and each represents a hydrogen atom, a hydroxyl group or a C₁-C₄ alkyl group provided that at least one of Y₁ and Y₂ is a hydroxyl group; Z₁, Z₂, Z₃, Z₄, Z₅, Z₆ and Z₇ are the same or different and each represents a hydrogen atom, a halogen atom, a hydroxyl group, a C₁-C₄ alkyl group, a C₅-C₈ cycloalkyl group or an aryl group provided that at least two are hydroxyl groups; and R₁, R₂, R₃, R₄ and R₅ are the same or different and each represents a hydrogen atom, a C₁-C₁₀ alkyl group, a C₂-C₄ alkenyl group, a cyclohexyl group or an aryl group provided that at least one of R₄ and R₅ is a C₁-C₁₀ alkyl group, a C₂-C₄ alkenyl group, a cyclohexyl group or an aryl group with the above quinone diazide sulfonic acid.

The quinone diazide compound may be prepared by a per se conventional method. For example, the quinone diazide sulfonic acid and the hydroxyl group-containing compound are condensed in the presence of a weak alkali.

Examples of the hydroxyl group-containing compound are hydroquinone, resorcinol, phloroglucin, 2,4-dihydroxybenzophenone, trihydroxybenzophenones (e.g. 2,3,4-trihydroxybenzophenone, 2,2',3-trihydroxybenzophenone, 2,2',4-trihydroxybenzophenone, 2,2',5-trihydroxybenzophenone, 2,3,3'-trihydroxybenzophenone, 2,3,4'-trihydroxybenzophenone, 2,3',4-trihydroxybenzophenone, 2,3',5-trihydroxybenzophenone, 2,4,4'-trihydroxybenzophenone, 2,4',5-trihydroxybenzophenone, 2',3,4-trihydroxybenzophenone, 3,3',4-trihydroxybenzophenone, 3,4,4'-trihydroxybenzophenone, etc.), tetrahydroxybenzophenones (e.g. 2,3,3',4'-tetrahydroxybenzophenone, 2,3,4,4'-tetrahydroxybenzophenone, 2,2',4,4'-tetrahydroxybenzophenone, 2,2',3,4-tetrahydroxybenzophenone, 2,2',3,4'-tetrahydroxybenzophenone, 2,2',5,5'-tetrahydroxybenzophenone, 2,3',4',5-tetrahydroxybenzophenone, 2,3',5,5'-tetrahydroxybenzophenone, etc.), pentahydroxybenzophenones (e.g. 2,2',3,4,4'-pentahydroxybenzophenone, 2,2',3,4,5'-pentahydroxybenzophenone, 2,2',3,3',4-pentahydroxybenzophenone, 2,3,3',4,5'-pentahydroxybenzophenone, etc.), hexahydroxybenzophenones (e.g. 2,3,3',4,4',5-hexahydroxybenzophenone, 2;2',3,3',4,5'-hexahydroxybenzophenone, etc.), alkyl gallates, the compound of the formula (I), a compound which is disclosed in Japanese Patent Kokai Publication No. 269351/1990 corresponding to U.S. Patent Application Ser. No. 07/347,065 and EP-A-0 341 608, and represented by the formula: 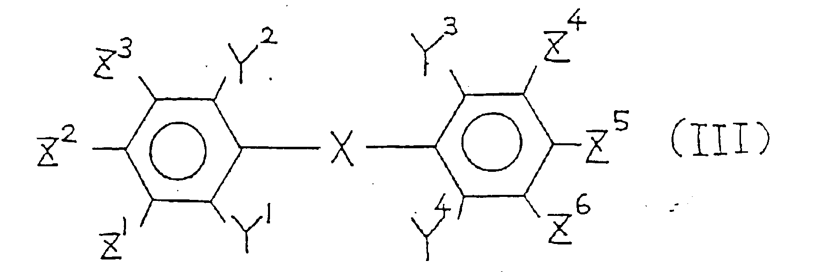 wherein Y¹, Y², Y³ and Y⁴ are the same or different and each represents a hydrogen atom, a halogen atom, an alkyl group or a hydroxyl group, provided that at least one is a hydroxyl group; Z¹, Z², Z³, Z⁴, Z⁵ and Z⁶ are the same or different and each represents a hydrogen atom, a halogen atom, an alkyl group, an aryl group or a hydroxyl group, provided that at least one is a hydroxyl group; and X is a group of the formula: -C(R¹)(R²)- in which R¹ and R² are the same or different and each represents a hydrogen atom, an alkyl group, an alkenyl group, a cycloalkyl group, an alkoxyl group or an aryl group, provided that when at least one is a hydrogen atom, an alkyl or aryl group is present at an ortho-position to a hydroxyl group which is present at an ortho-position to the group X.

As the alkali-soluble resin, polyvinylphenol, a novolak resin and the like are exemplified.

The novolak resin is prepared by a condensation reaction of a phenol with an aldehyde. Specific examples of the phenol used as one of the raw materials for the novolak resin include phenol, o-, m- or p-cresol, 2,5-, 3,5- or 3,4-xylenol,2,3,5-trimethylphenol, 4-, 2- or 3-tert.-butylphenol, 3-, 2- or 4-ethylphenol, 3-methyl-6-tert.-butylphenol, 4-methyl-2-tert.-butylphenol, 2-naphthol, 1,3-, 1,7- or 1,5-dihydroxynaphthalene, and the like. These phenols may be used alone or in combination.

Examples of the aldehyde are aliphatic aldehydes (e.g. formaldehyde, acetaldehyde, etc.), aromatic aldehydes (e.g. benzaldehyde, o-, m- or p-hydroxybenzaldehyde, o- or p-methylbenzaldehyde, etc.) and the like.

The weight ratio of the quinone diazide compound to the alkali-soluble resin is preferably from 1:1 to 1:7.

The weight ratio of 2-heptanone to ethyl lactate is from 95:5 to 20:80, preferably from 80:20 to 40:60.

When the ethyl lactate content is too low, the γ-value is greatly decreased. When the ethyl lactate content is too high, the coating property is deteriorated and the profile has a reverse tapered shape.

The solvent system to be used in the present invention is used in an amount such that a coating film is uniformly formed on the wafer and no pin hole or irregular coating is found. Preferably, the solvent system is used in an amount such that the total amount of the quinone diazide compound and the alkali-soluble resin is from 3 to 50 % by weight based on the total weight of the resist composition.

The positive resist composition is prepared by mixing and dissolving the quinone diazide compound and the alkali-soluble resin in the solvent system of the present invention.

The positive resist composition of the present invention may contain, other conventionally used additives such as sensitizers, other additional resins, surfactants, stabilizers or dyes which increase the visibility of the formed figure and conventional additives.

The positive resist composition of the present invention has a good coating property, an improved profile and a large depth of focus while maintaining the basic properties of the resist such as good heat resistance, resolution and sensitivity.

The present invention is illustrated in more detail by the following Examples, but it is not limited to these Examples. In these Examples, the "parts" are by weight.

### Examples 1 to 2 and Comparative Examples 1 to 5

A mixture of a novolak resin and a quinone diazide compound in amounts shown in the Table was dissolved in a solvent (45 parts). The resulting solution was filtered through a TEFLON (a trademark) filter of 0.2 µm in pore size. The resist solution was coated on a silicon wafer, which had been rinsed in a usual way, by means of a spinner so as to form a resist film of 1.3 µm thickness. Subsequently, the silicon wafer was baked for 60 seconds on a hot plate kept at 100°C, and exposed to light having a wavelength of 365 nm (i line) while varying the exposure time stepwise by means of a reduction projection exposing apparatus (LD-5010i with NA of 0.40 manufactured by Hitachi). Thereafter, the silicon wafer was post baked (post exposure baking, PEB) on a hot plate kept at 110°C for 60 seconds and developed for one minute in a developing solution (SOPD manufactured by Sumitomo Chemical Co., Ltd.) to obtain a positive pattern.

The resolution is evaluated by measuring the minimum size of the line-and-space pattern at which the pattern is separated without film thickness decrease at an exposure amount at which a line/space ratio (L/S) is 1:1 in the line-and-space pattern of 0.8 µm, with a scanning electron microscope.

The profile in the Table isthecross sectional shape of the 0.8 µm line-and-space pattern at the above exposure amount.

The γ-value is expressed in terms of tanθ, the angle θ of which is obtained by plotting a standardized film thickness (= the retained film thickness/the original film thickness) against the logarithm of the exposure amount, and calculating the inclination of the plotted line. The sensitivity (Eth) is an exposure amount at which the standardized film thickness is zero.

Heat resistance of the resist is expressed in terms of the maximum temperature at which a 3 µm line-and-space pattern is not deformed when the wafer having the pattern is heated on a hot plate for 3 minutes. The deformation of the pattern is observed with a scanning electron microscope.

The coating property is evaluated by uneveness of the coated film having a thickness of 2 µm.

The depth of focus is defined by measuring the width of focus values with which a 0.6 µm line-and-space pattern is separated at an exposure amount at which the line/space ratio is 1:1 without causing film thickness decrease and forming an extreme reverse tapered profile.

The results are shown in the Table below.

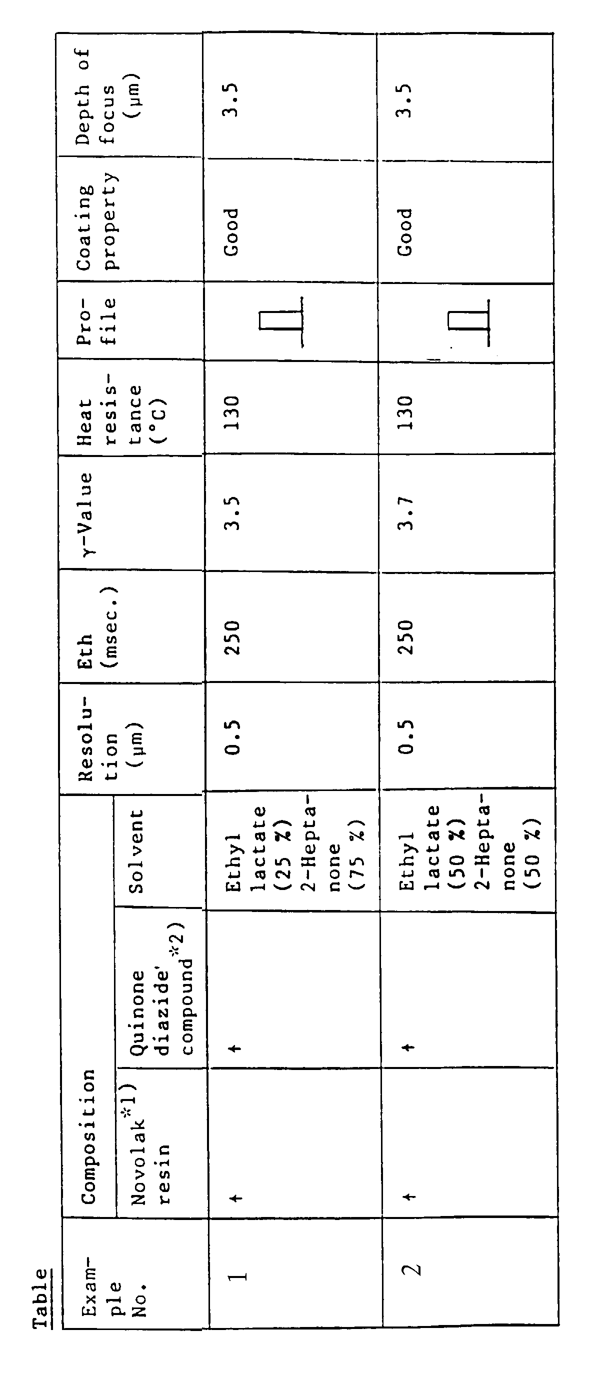

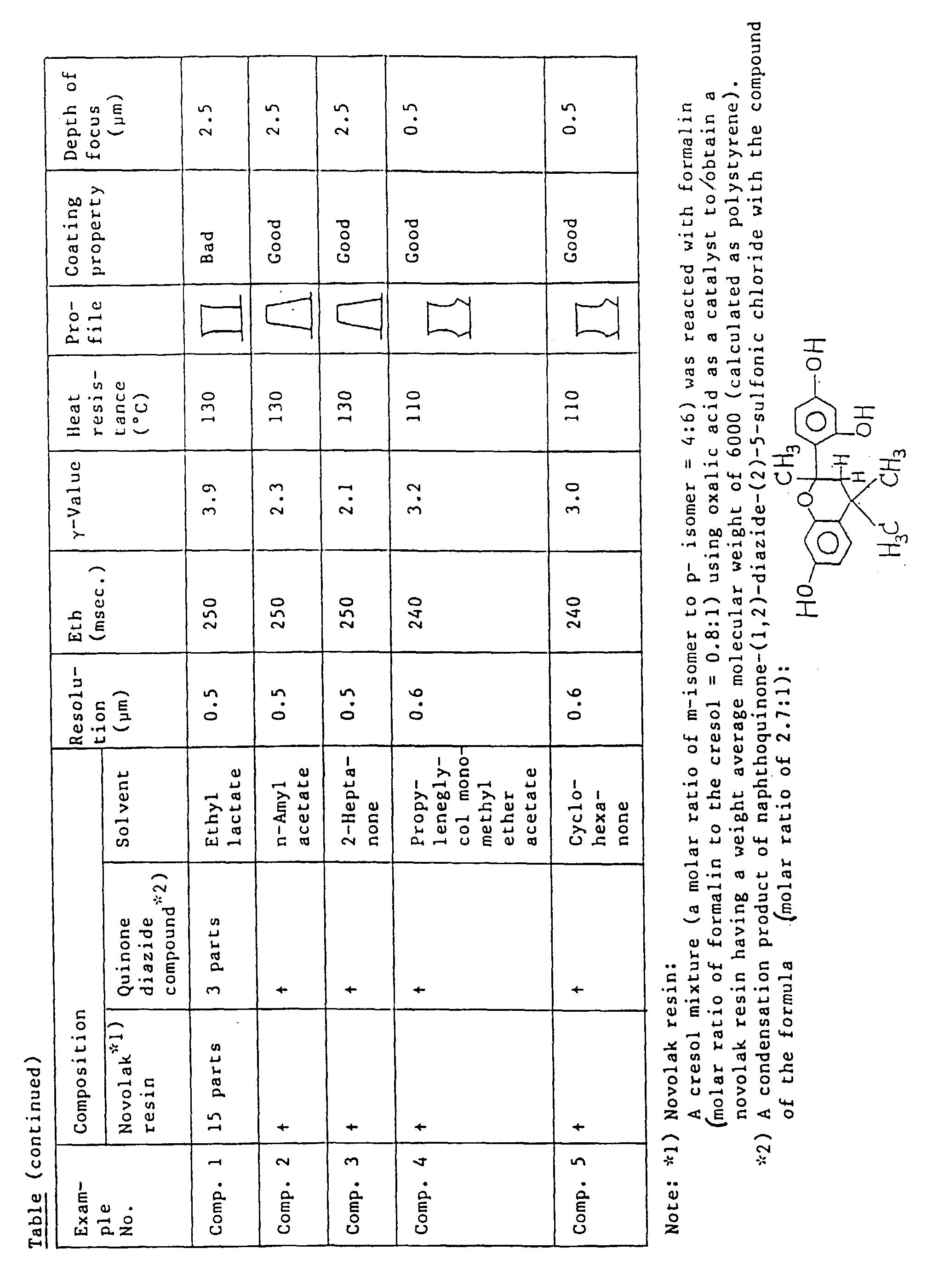

## Claims

1. A positive resist composition comprising, in admixture, an alkali-soluble resin, a quinone diazide compound and a mixed solvent of ethyl lactate and 2-heptanone in a weight ratio ethyl lactate to 2-heptanone within the range from 5:95 to 80:20.

2. The positive resist composition according to claim 1, wherein said quinone diazide compound is an ester of an oxyflavan compound of the formula: 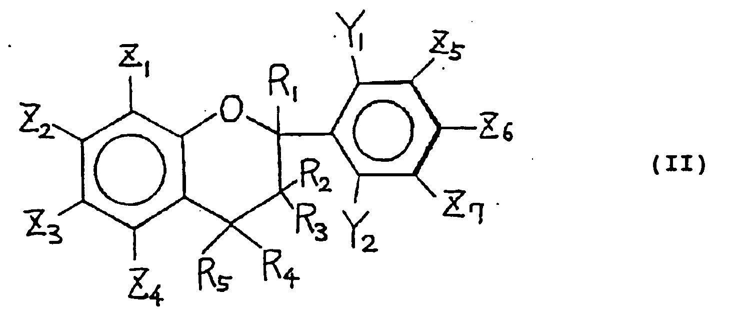 wherein Y₁ and Y₂ are the same or different and each represents a hydrogen atom, a hydroxyl group or a C₁-C₄ alkyl group, provided that at least one of Y₁ and Y₂ is a hydroxyl group; Z₁, Z₂, Z₃, Z₄, Z₅, Z₆ and Z₇ are the same or different and each represents a hydrogen atom, a halogen atom, a hydroxyl group, a C₁-C₄ alkyl group, a C₅-C₈ cycloalkyl group or an aryl group, provided that at least two of Z₁, Z₂, Z₃, Z₄, Z₅, Z₆ and Z₇ are hydroxyl groups, and R₁, R₂, R₃, R₄ and R₅ are the same or different and each represents a hydrogen atom, a C₁-C₁₀ alkyl group, a C₂-C₄ alkenyl group, a cyclohexyl group or an aryl group,provided that at least one of R₄ and R₅ is a C₁-C₁₀ alkyl group, a C₂-C₄ alkenyl group, a cyclohexyl group or an aryl group with a quinone diazide sulfonic acid.

3. The positive resist composition according to claim 1, wherein said alkali-soluble resin is a novolak resin.

4. The positive resist composition according to claim 1, wherein the weight ratio of ethyl lactate to 2-heptanone is within the range from 20:80 to 60:40.

## Patentansprüche

1. Positiv arbeitende Resistzusammensetzung, umfassend im Gemisch ein alkalilösliches Harz, eine Chinondiazidverbindung und ein Lösungsmittelgemisch aus Ethyllactat und 2-Heptanon in einem Gewichtsverhältnis Ethyllactat zu 2-Heptanon im Bereich von 5:95 bis 80:20.

2. Positiv arbeitende Resistzusammensetzung gemäß Anspruch 1, wobei die Chinondiazidverbindung ein Ester einer Oxyflavanverbindung der Formel 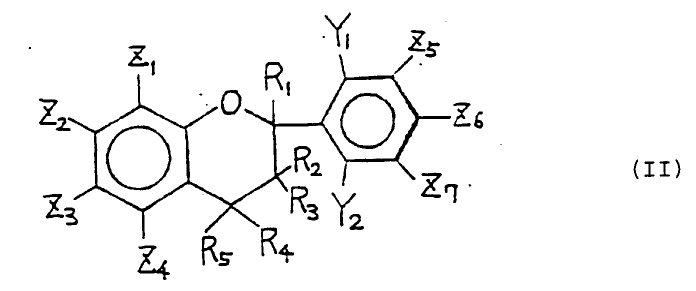 mit einer Chinondiazidsulfonsäure ist, wobei in der Formel II Y₁ und Y₂ gleich oder verschieden sind und jedes ein Wasserstoffatom, eine Hydroxylgruppe oder eine C₁-C₄-Alkylgruppe darstellt, mit der Maßgabe, daß Y₁ und/oder Y₂ eine Hydroxylgruppe ist; Z₁, Z₂, Z₃, Z₄, Z₅, Z₆ und Z₇ gleich oder verschieden sind und jedes ein Wasserstoffatom, ein Halogenatom, eine Hydroxylgruppe, eine C₁-C₄-Alkylgruppe, eine C₅-C₈-cycloalkylgruppe oder eine Arylgruppe darstellt, mit der Maßgabe, daß mindestens zwei von Z₁, Z₂, Z₃, Z₄, Z₅, Z₆ und Z₇ Hydroxylgruppen sind; und R₁, R₂, R₃, R₄ und R₅ gleich oder verschieden sind und jedes ein Wasserstoffatom, eine C₁-C₁₀-Alkylgruppe, eine C₂-C₄-Alkenylgruppe, eine Cyclohexylgruppe oder eine Arylgruppe darstellt, mit der Maßgabe, daß R₄ und/oder R₅ eine C₁-C₁₀-Alkylgruppe, eine C₂-C₄-Alkenylgruppe, eine cyclohexylgruppe oder eine Arylgruppe darstellt.

3. Positiv arbeitende Resistzusammensetzung gemäß Anspruch 1, wobei das alkalilösliche Harz ein Novolakharz ist.

4. Positiv arbeitende Resistzusammensetzung gemäß Anspruch 1, wobei das Gewichtsverhältnis von Ethyllactat zu 2Heptanon im Bereich von 20:80 bis 60:40 ist.

## Revendications

1. Composition de résist positif comprenant, en mélange, une résine soluble dans les alcalis, un composé quinonediazide et un mélange de solvants de lactate d'éthyle et de 2-beptanone dans un rapport pondéral de lactate d'éthyle à la 2-heptanone dans les intervalles de 5 : 95 à 80 ; 20.

2. Composition de résist positif selon la revendication 1, où ledit composé quinonediazide est un ester d'un composé oxyflavane de formule: 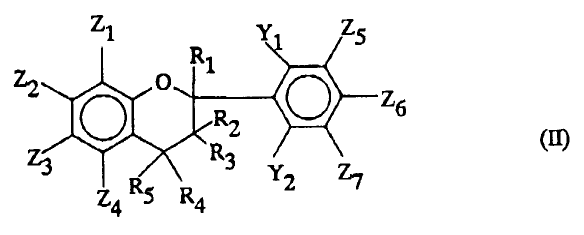 où Y₁ et Y₂ sont identiques ou différents et chacun représente un atome d'hydrogène, un groupe hydroxyle ou un groupe alkyle en C₁-C₄, à condition que l'un des groupes Y₁ et Y₂ est un groupe hydroxyle; Z₁, Z₂, Z₃, Z₄, Z₅, Z₆ et Z₇ sont identiques ou différents et chacun représente un atome d'hydrogène, un atome d'halogène, un groupe hydroxyle, un groupe alkyle en C₁-C₄, un groupe cycloalkyle en C₅-C₈ ou un groupe aryle, à condition qu'au moins deux des groupes Z₁, Z₂, Z₃, Z₄, Z₃, Z₆ et Z₇ sont des groupes hydroxyles, et que R₁, R₂, R₃, R₄ et R₅ sont identiques ou différents et chacun replésente un atome d'hydrogène, un groupe alkyle en C₁-C₁₀, un groupe alcényle en C₂-C₄, un groupe cyclohexylc ou un groupe aryle, à condition qu'au moins l'un des groupes choisis parmi R4 et R₅ est un groupe alkyle en C₁-C₁₀, un groupe alcényle en C₂-C₄ ; un groupe cyclohexyle ou un groupe aryle ; avec un acide quinonediazide sulfonique.

3. Composition de résist positif selon la revendication 1, où ladite résine soluble dans les alcalis est une résine novolaque.

4. Composition de résist positif selon la revendication 1 où le rapport pondéral du lactate d'éthyle à la 2-heptanone est dans l'intervalle de 20 : 80 à 60 : 40.
